# EUROPÄISCHE PATENTANMELDUNG

(11) **EP 3 471 519 A1**
(43) Veröffentlichungstag der Anmeldung: **17.04.2019**
(21) Anmeldenummer: 18199679.4
(22) Anmeldetag: 10.10.2018
(51) Int. Cl.: H05K 3/30, H03K 17/97, H01H 25/04

(54) **FERNSTEUERUNG MIT SICHERUNGSRING**

(30) Priorität: 16.10.2017 DE 102017124045
(71) Anmelder: FM Marketing GmbH, 5202 Neumarkt am Wallersee (AT)
(72) Erfinder: Weißl, Christian, 5203 Köstendorf (AT); Maier, Ferdinand, 5202 Neumarkt am Wallersee (AT)
(74) Vertreter: von Bülow & Tamada

(57) **Zusammenfassung**

Die Fernsteuerung hat eine Leiterbahnplatte (12), an der eine Führungsscheibe (29) mit vorstehenden Verriegelungszapfen (18) angebracht ist. Die Verriegelungs-zapfen (18) greifen durch Öffnungen (15) der Leiterbahnplatte (12) zu deren gegenüberliegenden Seite hindurch und haben radiale Verriegelungsvorsprünge. Auf der zweiten Seite der Leiterbahnplatte (12) ist eine Verriegelungsscheibe (20) mit Ausnehmungen (23,24) vorgesehen, die hinter die verdickten Köpfe (27) der Verriegelungszapfen (27) greifen können und somit die Verriegelungsscheibe (20) fixieren, womit die auf beiden Seiten der Leiterbahnplatte (12) liegenden Scheiben (20, 29) an der Leiterbahnplatte (12) fixiert sind. Auch die gegenseitigen Positionen der beiden Scheiben (20, 29) werden damit eindeutig festgelegt.

## Beschreibung

Die Erfindung bezieht sich auf eine Fernsteuerung.

In der DE 10 2015 119 485 A1 ist eine Fernsteuerung mit Magneten beschrieben, die eine durch einen Benutzer drückbare Taste zum Einlesen von Informationen durch Druck des Benutzers in einer Druckrichtung, einen in der Druckrichtung gesehen an der Unterseite der Taste befestigten Gebermagneten und einen in der Druckrichtung gesehen unterhalb der Taste und gegenüber der Taste ortsfest angeordneten Ankermagneten aufweist, wobei die Magnetpole des Gebermagneten und des Ankermagneten derart angeordnet sind, dass die Taste mit dem Gebermagneten von dem Ankermagneten fort gegen die Druckrichtung gedrückt wird.

Fernsteuerungen, bei denen Eingabeelemente, wie Tasten, durch Magnete mit haptisch wahrnehmbaren Kräften beaufschlagt werden, sind beispielsweise aus der DE 10 2011 014763 A1 und DE 10 2010 019596 A1 bekannt.

In der älteren Patentanmeldung DE 10 2016 112318 ist eine Fernsteuerung mit einem Gehäuse und einem Steuerkreuz beschrieben, bei dem das Steuerkreuz mehrere radial gegenüber einem Mittelpunkt versetzt angeordnete Tastenbereiche aufweist, die relativ zum Gehäuse in einer Druckrichtung in das Gehäuse hinein drückbar sind. Am Steuerkreuz sind mehrere Zapfen mit verdicktem Kopf direkt oder indirekt angebracht. Eine gehäusefeste Führungsplatte oder Führungsscheibe zur Führung des Steuerkreuzes in der Druckrichtung weist an die verdickten Köpfe angepasste Lagerschalen auf. Abschnitte der Zapfen erstrecken sich durch Öffnungen einer Leiterbahnplatte hindurch und die Lagerschalen und die verdickten Köpfe sind als Begrenzungsanschlag für eine Bewegung des Steuerkreuzes entgegen der Druckrichtung ausgebildet. Die Zapfen mit verdicktem Kopf sind an der zur Leiterbahnplatte weisenden Unterseite in Hülsen eingesteckt und beispielsweise durch Kleben mit den Hülsen verbunden. Die Köpfe und Lagerschalen wirken als Begrenzungsanschlag und gleichzeitig als Zentrierung für die Ausrichtung des Steuerkreuzes. In Gegenrichtung, also beim Niederdrücken durch einen Benutzer, ist die Bewegung des Steuerkreuzes in der Druckrichtung auf die Leiterbahnplatte dadurch begrenzt, dass die Unterseite des Steuerkreuzes gegen die Führungsplatte anstößt.

Zur oben genannten gehäusefesten Anordnung der Führungsplatte kann diese auf der Leiterbahnplatte beispielsweise durch Verschrauben, Verkleben, Verstemmen oder anderen bekannten Anbindemechanismen befestigt sein. Insgesamt sind die bekannten Anbindemechanismen jedoch alle relativ aufwendig und teuer bei der Herstellung der Fernsteuerung.

Aufgabe der Erfindung ist es daher, die Herstellung der Fernsteuerung der eingangs genannten Art zu vereinfachen und trotzdem eine gute Fixierung der Führungsplatte oder Führungsscheibe auf der Leiterbahnplatte in ihrer gewünschten Position zu erhalten.

Nach der Erfindung hat eine Fernsteuerung eine Leiterbahnplatte üblicher Bauart mit mehreren Öffnungen. An einer ersten Seite der Leiterbahnplatte ist eine Führungsscheibe oder Führungsplatte mit vorstehenden Verriegelungszapfen angebracht, die durch Öffnungen der Leiterbahnplatte zu deren gegenüberliegenden Seite hindurch ragen. Die Verriegelungszapfen haben radiale Verriegelungsvorsprünge. Auf der zweiten Seite der Leiterbahnplatte ist eine Verriegelungsscheibe mit Ausnehmungen vorgesehen, die hinter die verdickten Köpfe der Verriegelungszapfen greifen können und somit die Verriegelungsscheibe fixieren, womit die auf beiden Seiten der Leiterbahnplatte liegenden Scheiben an der Leiterbahnplatte fixiert sind.

Die Verriegelungszapfen weisen radiale Vorsprünge auf, die sich nur über einen begrenzten Umfang der Verriegelungszapfen erstrecken, wobei vorzugsweise jeder Verriegelungszapfen zwei radiale Vorsprünge aufweist, deren Mittelachsen gegeneinander um 180° versetzt angeordnet sind.

In Anpassung an die gewünschten Funktionen ist die Verriegelungsscheibe vorzugsweise ringförmig und hat für jeden Verriegelungszapfen eine in etwa U-förmige Führung, an die ein zugeordneter Verriegelungszapfen angreift und mit seinen radialen Vorsprüngen die Verriegelungsscheibe mit der gegenüberliegenden Scheibe an der Leiterbahnplatte fixiert.

Für eine gut verspannte Fixierung hat die U-förmige, bahnförmige Führung der Verriegelungsscheibe eine Auflaufschräge, an der ein zugeordneter radialer Vorsprung der Verriegelungszapfen angreift.

Vorzugsweise hat die Fernsteuerung vier Verriegelungszapfen, die jeweils um 90° am Umfang der ersten Scheibe versetzt angeordnet sind.

Weiter ist von Vorteil, dass jeweils ein Schenkel der U-förmigen Führung federelastisch in Richtung zum Außenumfang der Verriegelungsscheibe vorgespannt ist. Damit wird eine eindeutige Fixierung erreicht sowie eine einfache Montage.

Die Leiterbahnplatte weist für jeden Verriegelungszapfen eine Öffnung auf, die an die Form der Verriegelungszapfen mit den radialen Vorsprüngen angepasst ist.
Weiter ist von Vorteil, dass die Verriegelungszapfen hohlzylindrisch sind und in zylindrische Führungspfosten der Steuerscheibe eingreifen, die als weitere Führung wirken.

Vorzugsweise sind die Führungsscheibe und die Verriegelungsscheibe generell kreisförmig.

Im folgenden wird die Erfindung anhand eines Ausführungsbeispiele ausführlich erläutert. Es zeigt:

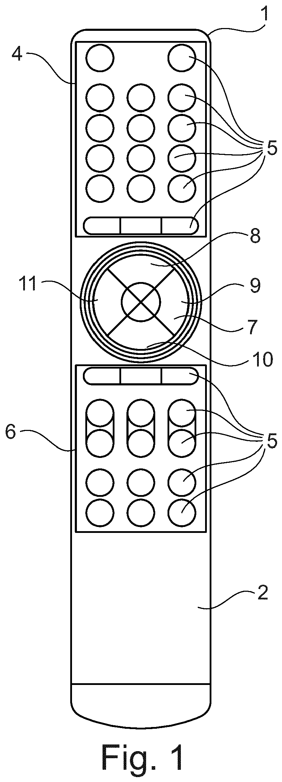

Fig.1 eine Draufsicht auf eine Fernsteuerung nach der Erfindung;
Fig. 2 eine Explosionsdarstellung der wesentlichen Teile der Erfindung gesehen in einer ersten Blickrichtung unter Fortlassung der sonstigen Teile einer Fernsteuerung;
Fig. 3 eine Explosionsdarstellung ähnlich Fig. 2 gesehen in einer zweiten Blickrichtung
Fig. 4 eine schematische Darstellung eines bei der Erfindung verwendeten Verriegelungsringes
Fig. 5 eine schematische Darstellung der bei der Erfindung verwendeten Verriegelungszapfen.

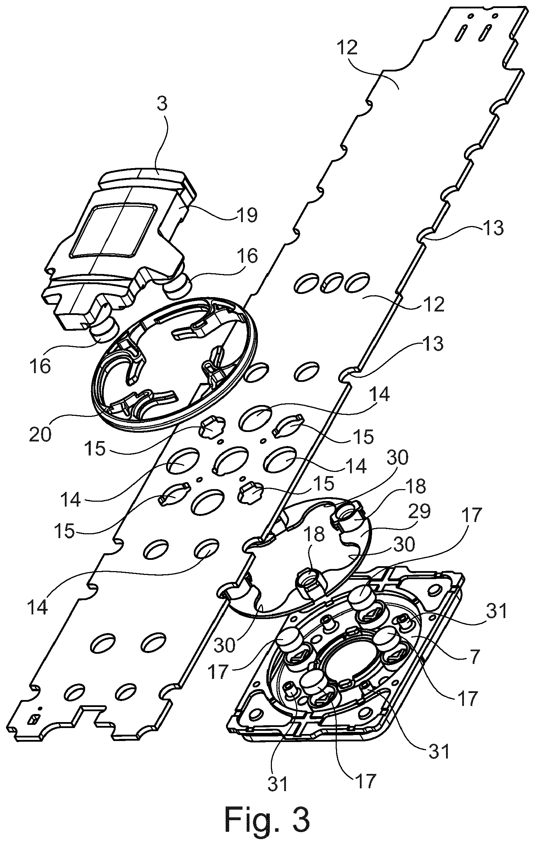

Die Fernsteuerung 1 umfasst ein Gehäuse, das aus einer Oberschale 2 und einer Unterschale 3 (von der in Fig. 3 nur ein Teilabschnitt dargestellt ist) zusammengesetzt ist, sowie ein erstes Tastenfeld 4 mit einer Vielzahl von Tasten 5 und ein zweites Tastenfeld 6 mit jeweils einer Vielzahl von Tasten 5. In den Figuren sind der Übersichtlichkeit halber nicht alle Tasten 5 mit einem Bezugszeichen versehen. Beide Tastenfelder 4 und 6 sind über ein Steuerkreuz 7 voneinander getrennt. Das Steuerkreuz 7 hat hier vier Tastenbereiche 8, 9,10 und 11, die jeweils um 90° gegeneinander versetzt sind und im Wesentlichen jeweils den Bereich eines Quadranten überdecken. Das Steuerkreuz 7 kann jeweils an einem der Tastenbereiche 8, 9,10 oder 11 niedergedrückt werden, wodurch im Ergebnis bestimmte Befehle für ein fernzusteuerndes Gerät ausgelöst werden. Mit den vier Tastenbereichen 8, 9, 10 oder 11 können somit vier verschiedene Befehle ausgelöst werden. Eine andere Anzahl von unterscheidbaren Tastenbereichen kann vorgesehen sein, wobei aus Gründen der Praktikabilität nicht mehr als acht verschiedene Tastenbereiche vorgesehen sein sollten.

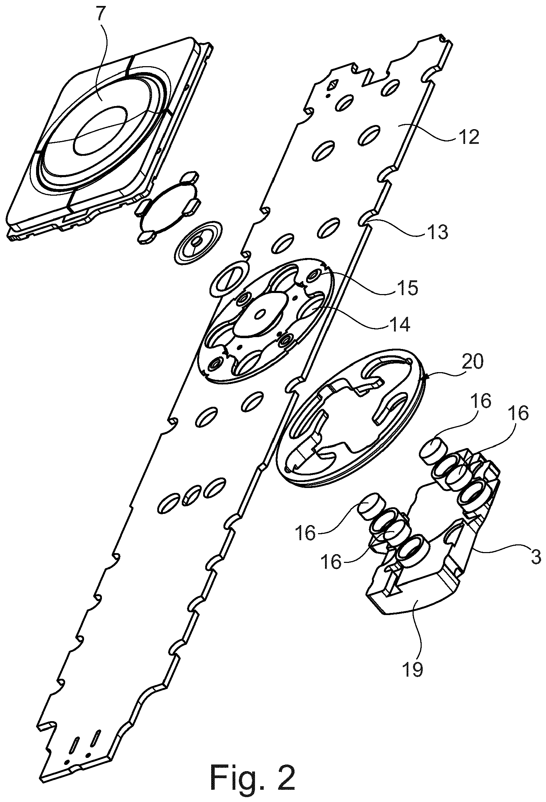

Bei der Erfindung geht es im Wesentlichen um die Führung des Steuerkreuzes 7 an der Fernsteuerung 1 beim Niederdrücken der Tastenbereiche 8, 9, 10 oder 11. Die Figuren 2 und 3 zeigen eine Leiterbahnplatte 12, auf der die wesentlichen elektrischen und elektronischen Bauteile untergebracht sind, wobei diese der Übersichtlichkeit halber hier fortgelassen sind.

Die Leiterbahnplatte 12 hat an ihren Rändern mehrere Ausnehmungen 13, mit denen sie an zugeordneten Vorsprüngen der Unterschale 3 positioniert werden kann. In dem Bereich, an dem das Steuerkreuz 7 positioniert wird, hat die Leiterbahnplatte 12 zwei Gruppen von Öffnungen 14 und 15, wobei jeder Öffnung 14 ein Paar Magnete 16 und 17 zugeordnet ist, während die Öffnungen 15 für den Durchtritt von Verriegelungszapfen 18 vorgesehen sind, die an einer noch zu beschreibenden Führungsscheibe oder Führungsplatte in Form einer Ringscheibe 29 angebracht sind. Jedes Paar Magnete 16 und 17 stellt einen Teil eines nicht weiter referenzierten Tastenbetätigungssensors dar. Jedes Paar Magnete 16 und 17 ist, wie näher in der DE 10 2016112318 beschrieben, gegenpolig magnetisiert, so dass sie sich gegenseitig abstoßende Kräfte erzeugen, wobei in jedem Tastenbetätigungssensor ein nicht dargestellter Magnetsensor im Wirkungsbereich der sich jeweils gegenüberliegenden Magnete 16 und 17 angeordnet ist. Die Magnete 17 sind fest am Steuerkreuz 7 angebracht und können sich nur zusammen mit dieser bewegen. Ebenfalls sind die Magnete 16 fest an einer Halterung 19 angebracht, die auch Teil der Unterschale 3 sein kann. Lediglich der Einfachheit halber ist hier die Halterung 19 als separates Bauteil dargestellt. Die Magnete 16 und 17, die jeweils paarweise einander zugeordnet sind, greifen also mit ihrem Magnetfeld durch die Öffnungen 14 der Leiterbahnplatte 12 hindurch, wobei sich beim Niederdrücken eines der Bereiche 9 bis 11 der Leiterbahnplatte 12 der Abstand der einander zugeordneten Magnete 16 und 17 verändert, was von den nicht dargestellten Sensoren erfasst und einer ebenfalls nicht dargestellten und zum jeweiligen Tastenbetätigungssensor gehörenden elektronischen Auswerteschaltung ausgewertet werden kann, zur Auslösung von Steuerbefehlen, die von der Fernsteuerung 1 ausgegeben werden.

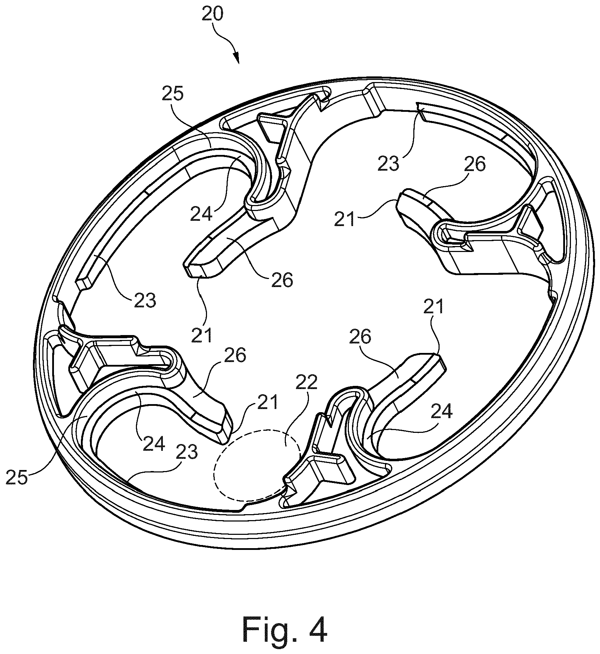

Die Verriegelungszapfen 18 greifen von der Seite des Steuerkreuzes 7 durch die Öffnungen 15 der Leiterbahnplatte 12 hindurch und kommen mit ihrem Wirkungsbereich zu einem Verriegelungsring 20, der auf der gegenüberliegenden Seite der Leiterbahnplatte 12 angeordnet ist und auf dieser aufliegt. Dieser Verriegelungsring 20 ist detaillierter in Figur 4 dargestellt und wird im Zusammenhang mit den Verriegelungszapfen 18 beschrieben.

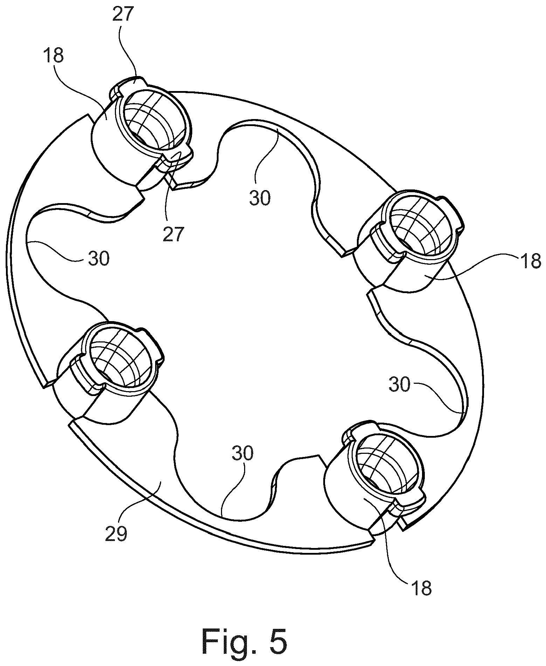

Der Verriegelungsring 20 hat eine ebene Unterseite, mit der er auf der Unterseite der Leiterbahnplatte 12 aufliegt. Die Außenkontur des Verriegelungsringes 20 ist hier kreisförmig. Im Innenbereich hat der Verriegelungsring 20 entsprechend der Anzahl von Verriegelungszapfen 18 eine Anzahl von in etwa U-förmigen, mittig etwa kreissegmentförmig gebogenen, in Umfangsrichtung ausgerichteten Armen 21, die gestuft sind. Zwischen zwei benachbarten Armen 21 ist ein Eintrittsbereich 22 gestrichelt dargestellt, der an den Durchmesser der Verriegelungszapfen 18 angepasst ist. Anschließend an diesen Eintrittsbereich 22 folgt dem jeweiligen Arm 21 radial gegenüberliegend eine in Umfangsrichtung ansteigende Auflaufschräge 23, die in einen etwa halbkreisförmigen Bereich 24 konstanter Höhe übergeht, wobei sich an diesen Bereich axial nach oben ein zweiter halbkreisförmiger Bereich 25 anschließt, der in etwa die Höhe der Außenkontur des Verriegelungsringes 20 aufweist. An den halbkreisförmigen Bereich 24 schließt sich jeweils ein Haltearmelement 26 an, das in radialer Richtung zur Außenseite des Verriegelungsringes 20 leicht geneigt ist und somit für die Verriegelungszapfen 18 eine Verengung bildet, die für einen Halt des Verriegelungsringes 20 an den jeweiligen Verriegelungszapfen 18 sorgt. Der Haltearm 26 ist aufgrund der Materialeigenschaften des Verriegelungsringes 20 federelastisch. Damit werden die Verriegelungszapfen 18 und der Verriegelungsring 20 aneinander fixiert. Die Verriegelungszapfen 18 sind in Figur 5 dargestellt. Sie sind gemeinsam an der oben erwähnten Ringscheibe 29 befestigt oder sogar dort einstückig mit der Ringscheibe 29 verbunden. Damit ist ihre Ausrichtung in Bezug auf die Eintrittsbereiche 22 eindeutig festgelegt. Ihre Kontur ist zylindrisch mit einem verdickten Kopfbereich, der aus über einen gewissen Umfang radial vorstehenden Verriegelungsvorsprüngen 27 besteht, die sich zumindest in radialer Richtung der Ringscheibe 29 nach innen und nach außen erstrecken. Die Verriegelungsvorsprüngen 27 liegen bei fertig montiertem Verriegelungsring 20 zumindest bereichsweise auf dem halbkreisförmigen Bereich 24 auf, wobei sich radiale Außenflächen der Verriegelungsvorsprüngen 27 an der Innenwand des Verriegelungsringes 20 abstützen und somit eine Führung bilden können. Die Verriegelungsvorsprünge 27 erstrecken sich nur über einen begrenzten Umfangsbereich. Dementsprechend haben auch die Öffnungen 15 der Leiterbahnplatte 12 daran angepasste Öffnungsbereiche, die kreisförmig sind und an die sich für die Verriegelungsvorsprünge 27 entsprechende radiale Aufweitungen anschließen.

Die Verriegelungsvorsprünge 27 an jedem Verriegelungszapfen 18 sind aufgrund der oben genannten radialen Ausrichtung der Ringscheibe 29 um 180° gegeneinander in Umfangsrichtung versetzt.

Wie aus Fig. 3 und 5 am besten zu erkennen ist, sind die Verriegelungszapfen 18 an der Ringscheibe 29 befestigt, womit auch die Position der Verriegelungsvorsprünge 27 eindeutig definiert ist. Die Ringscheibe 29 ist hier kreisförmig und hat im Innenbereich Ausnehmungen 30 für die Lage der Magneten 17, so dass diese Ringscheibe 29 und damit auch die Verriegelungszapfen 18 stets eindeutig positioniert und ausgerichtet sind.

Bei der Montage wird neben den sonstigen Bauteilen das Steuerkreuz 7 mit dem an ihm befestigten Magneten 17 und den an ihr ebenfalls mit der Ringscheibe 29 befestigten Verriegelungszapfen 18 auf die Oberseite der Leiterbahnplatte 12 gesetzt, so dass die Magnete 17 in den Bereich der Öffnungen 14 zu liegen kommen, während die Verriegelungszapfen 18 der Ringscheibe 29 durch die Öffnungen 15 hindurch greifen und zwar so weit, dass der an die Verriegelungsvorsprünge 27 angrenzende Bereich der Verriegelungszapfen 18 über die Unterseite der Leiterbahnplatte 12 hinausragt. Die Ringscheibe 29 liegt dabei plan auf der Leiterbahnplatte 12 auf. Mit so eingesetzter Ringscheibe 29 kann der Verriegelungsring 20 auf der gegenüberliegenden Seite der Leiterbahnplatte 12 aufgesetzt werden, so dass anfänglich die Verriegelungszapfen 18 in dem Eintrittsbereich 22 liegen, wobei bei anschließender Drehung des Verriegelungsringes 20 die radial vorstehenden Verriegelungsvorsprünge 27 der Verriegelungszapfen 18 längs der Auflaufschräge 23 gleiten, bis sie am Bereich 24 ankommen, womit dann der Verriegelungsring 20 fixiert ist und die Ringscheibe 29 festhält. Bei diesem Einführen federn die Haltearme 26 leicht radial zur Mitte des Verriegelungsringes 20 und federn dann wieder zurück in Richtung ihrer Ausgangsstellung, wenn die Verriegelungszapfen 18 in der Endposition sind, also an dem zweiten halbkreisförmigen Bereich 25 angekommen sind. Damit sind die Steuerscheibe 7 und der Verriegelungsring 20 an der Leiterbahnplatte 12 eindeutig fixiert.

Aufgabe der Ringscheibe 29 im so an der Leiterbahnplatte 12 fixierten Zustand ist es, gesehen von einer Rotationsachse der Ringscheibe 29 aus, eine radial nach innen und außen gerichtete Bewegung der Tastenbereiche 8, 9,10 und 11 des Steuerkreuzes 7 zu verhindern. Auf diese Weise werden die Tastenbereiche 8, 9, 10 und 11 in axialer Richtung geführt, so dass diese ausschließlich zur Leiterbahnplatte 12 hin und weg gerichtet bewegt werden können, um die oben genannte Erfassung eines Niederdrückens der Tastenbereiche 8, 9, 10 und 11 messfehlerfrei zu ermöglichen, wenn die Magnete 16 und 17 zusammen- und auseinandergeführt werden. Ferner wird so ein Reiben des Steuerkreuzes 7 an der Oberschale 2 vermieden.

Gegenüber anderen Befestigungsmethoden der Ringscheibe 29 an der Leiterbahnplatte 12, wie Kleben, Verschrauben, Verrasten, und so weiter ist die oben beschriebene Lösung langlebig, kostengünstig und montagefreundlich.

Zur Verbesserung der zuvor genannten axialen Führung der Tastenbereiche 8, 9,10 und 11 des Steuerkreuzes 7 sind die Verriegelungszapfen 18 hohlzylindrisch ausgebildet und axial zum Steuerkreuz 7 hin geöffnet. An einer zur Leiterbahnplatte 12 hin gerichteten Seite der Tastenbereiche 8, 9,10 und 11 des Steuerkreuzes 7 sind Führungspfosten 31 ausgebildet, die axial in die hohlzylindrischen Verriegelungszapfen 18 eingreifen.

## Patentansprüche

1. Fernsteuerung mit einer eine erste Seite und eine der ersten Seite gegenüberliegenden zweiten Seite aufweisende Leiterbahnplatte und ein Steuerkreuz mit mehreren Tastenbereichen auf der ersten Seite der Leiterbahnplatte, die Tastenbetätigungssensoren zugeordnet sind, mit einer auf der ersten Seite der Leiterbahnplatte angeordneten Führungsscheibe (29) mit von ihr abstehenden Verriegelungszapfen (18), die von der ersten Seite durch Öffnungen (15) der Leiterbahnplatte (12) auf die zweite Seite der Leiterbahnplatte geführt sind, wobei die Verriegelungszapfen (18) radiale Verriegelungsvorsprünge (27) aufweisen, wobei auf der zweiten Seite der Leiterbahnplatte (12) eine Verriegelungsscheibe (20) mit Ausnehmungen (23,24) vorgesehen ist, an denen die Verriegelungsvorsprünge (27) der Verriegelungszapfen (18) angreifen.

2. Fernsteuerung nach Anspruch 1, **dadurch gekennzeichnet, dass** sich die radialen Verriegelungsvorsprünge (27) über einen begrenzten Umfang der Verriegelungszapfen (18) erstrecken.

3. Fernsteuerung nach Anspruch 2, **dadurch gekennzeichnet, dass** an jedem Verriegelungszapfen (18) zwei radiale Verriegelungsvorsprünge (27) vorgesehen sind, deren Mittelachsen gegeneinander um 180° versetzt sind.

4. Fernsteuerung nach einem der Ansprüche 1 bis 3, **dadurch gekennzeichnet, dass** die Verriegelungsscheibe (20) ringförmig ist und für jeden Verriegelungs-zapfen (18) eine in etwa U-förmige Führung (23, 24,26) hat, in die ein zugeordneter Verriegelungszapfen (18) eingreift und mit seinen radialen Verriegelungsvorsprüngen (27) die Verriegelungsscheibe (20) mit der ersten Scheibe an der Leiterbahnplatte (12) fixiert.

5. Fernsteuerung nach Anspruch 4, **dadurch gekennzeichnet, dass** die U-förmige Führung der Verriegelungsscheibe (20) eine Auflaufschräge (23) aufweist, an der ein zugeordneter radialer Verriegelungsvorsprung (27) der Verriegelungszapfen (18) angreift.

6. Fernsteuerung nach einem der Ansprüche 1 bis 5, **dadurch gekennzeichnet, dass** die Fernsteuerung vier Verriegelungszapfen (18) aufweist, die jeweils um 90° am Umfang der ersten Scheibe (29) versetzt angeordnet sind.

7. Fernsteuerung nach Anspruch 4 oder 5, **dadurch gekennzeichnet, dass** jeweils ein Schenkel (26) der U-förmigen Führung federelastisch in Richtung zum Außenumfang der Verriegelungsscheibe (20) vorgespannt ist.

8. Fernsteuerung nach einem der Ansprüche 2 bis 7, **dadurch gekennzeichnet, dass** die Öffnungen (15) für die Verriegelungszapfen (18) an die Form der jeweiligen Verriegelungszapfen (18) mit den radialen Vorsprüngen (27) angepasst sind.

9. Fernsteuerung nach einem der vorstehenden Ansprüche, **dadurch gekennzeichnet, dass** die Verriegelungszapfen (18) hohlzylindrisch sind, in die zylindrische Führungspfosten (31) der Steuerscheibe (7) eingreifen.
